# EUROPEAN PATENT APPLICATION

(11) **EP 1 662 326 A1**
(43) Date of publication of application: **31.05.2006**
(21) Application number: 04772484.4
(22) Date of filing: 31.08.2004
(51) Int. Cl.: G03F 7/32, G03F 7/00

(54) **DEVELOPER FOR POSITIVE PHOTOSENSITIVE COMPOSITION**

(30) Priority: 01.09.2003 JP 2003308803
(71) Applicant: THINK LABORATORY CO., LTD., Chiba, 227-8525 (JP)
(72) Inventor: SATO, Tsutomu, Kashiwa-shi, Chiba 2778525 (JP)
(74) Representative: Grünecker, Kinkeldey, Stockmair & Schwanhäusser Anwaltssozietät
(86) International application number: PCT/JP2004/012528
(87) International publication number: WO 2005/022267

(57) **Abstract**

There is provided a developer for a positive photosensitive composition, which has a developing treatment capability enough to endure many times of use, is small in variations of a pH value for a long period of time, is excellent in durability, in particular has the developing capability enough to develop 100 rolls or more, preferably 300 to 400 rolls, so as to be practically usable for a roll to be processed for gravure printing, is extremely small in deterioration with time in the treatment capability, and is small in frequency to exchange the developer. The developer comprises an alkaline solution containing: (A) quaternary ammonium hydroxide; and (B) at least one selected from the group consisting of potassium pyrophosphate, sodium tripolyphosphate and sodium hexametaphosphate.

## Description

### Technical Field:

The present invention relates to a developer for a positive photosensitive composition, and more specifically, to a developer for use in developing a positive photosensitive composition having sensitivity to an infrared wavelength laser, in which a sensing portion becomes soluble to the developer by being exposed to and sensing the infrared wavelength laser.

### Background Art:

Heretofore, there has been known a positive photosensitive composition having sensitivity to a near-infrared wavelength laser, in which a sensing portion becomes soluble to a developer by being exposed to and sensing the near-infrared wavelength laser (for example, refer to Patent Documents 1 to 6 and the like). It is impossible to develop this type of positive photosensitive composition without using a strong alkaline developer having a pH value of approximately 13 or more. Patent Documents 7 and 8 and the like disclose developers for the positive photosensitive composition. However, these developers are for use in a lithographic printing plate, and when the developers were diverted for gravure printing and were tested, the developers were deteriorated instantaneously after developing one roll, and were not able to develop the second and later rolls at all.

In order to put such a developer into practical use in the gravure printing, it is desirable that the developer has the capability to develop at least approximately 100 rolls, and that deterioration with time in the treatment capability thereof is extremely small, that is to say, there is no fear that the developing capability has disappeared to disable the development when the developer is used again after the elapse of a few days to one week, with the result that the developer in a developer tank is entirely discharged and another developer is prepared again.
Patent Document 1: Japanese Patent Laid-Open Publication No. H10-26826 (published in 1998)
Patent Document 2: Japanese Patent Laid-Open Publication No. H10-161304 (published in 1998)
Patent Document 3: Japanese Patent Laid-Open Publication No. H10-90881 (published in 1998)
Patent Document 4: Japanese Patent Laid-Open Publication No. H11-231515 (published in 1999)
Patent Document 5: Japanese Patent Laid-Open Publication No. 2003-337409
Patent Document 6: Japanese Patent Laid-Open Publication No. 2004-102062
Patent Document 7: Japanese Patent Laid-Open Publication No. H8-23447 (published in 1996)
Patent Document 8: Japanese Patent Laid-Open Publication No. S61-167948 (published in 1986)

### Disclosure of the Invention:

### Problems to be solved by the Invention:

The present invention has been made in view of the above-described points. It is an object of the present invention to provide a developer for a positive photosensitive composition, which has the developing treatment capability enough to endure many times of use, is small in variations of a pH value for a long period of time, is excellent in durability, in particular has the developing capability enough to develop 100 rolls or more, preferably 300 to 400 rolls, so as to be practically usable for a roll to be processed for gravure printing, is extremely small in deterioration with time in the treatment capability, and is small in frequency to exchange the developer.

### Means for Solving the Problems

In order to solve the above-described problems, a developer for a positive photosensitive composition according to the present invention comprises an alkaline solution containing: (A) quaternary ammonium hydroxide; and (B) at least one selected from the group consisting of potassium pyrophosphate, sodium tripolyphosphate and sodium hexametaphosphate.

In the developer according to the present invention, the alkaline solution preferably further contains (C) trisodium phosphate. Moreover, in the developer according to the present invention, the alkaline solution preferably further contains (D) a surfactant. Furthermore, in the developer according to the present invention, the alkaline solution preferably further contains (E) an accelerator.

It is preferable that the quaternary ammonium hydroxide (A) is at least one selected from the group consisting of tetramethylammonium hydroxide, tetraethylammonium hydroxide, tetrapropylammonium hydroxide, tetrabutylammonium hydroxide, benzyltrimethylammonium hydroxide and benzyltriethylammonium hydroxide.

### Effect of the Invention:

According to the present invention, there can be provided a developer for a positive photosensitive composition, which has a developing treatment capability enough to endure many times of use, and in which variations of a pH value are small for a long period of time and durability is excellent, and in particular, which is suitably used for developing treatment using a gravure printing plate. In the case of applying the developer for a positive photosensitive composition according to the present invention to a roll to be processed for the gravure printing, even if 300 rolls or more are treated, the pH value is stably maintained at approximately 13 or more, and a good development with good pattern sharpness can be realized in a short time. Moreover, deterioration with time in the treatment capability is extremely small. Accordingly, it is not necessary to entirely discharge the developer in a developer tank and to exchange the developer with a new developer, which may be caused by the fact that the developing capability has disappeared to disable the development when the developer is used again after the elapse of two to three days to one week. The developer according to the present invention exerts such enormous effects as described above.

### Best Mode for Carrying Out the Invention:

Although embodiments of the present invention are described below, it is needless to say that the embodiments are described only for illustration purposes, and that various modifications are possible without departing from a technical concept of the present invention.

A developer for a positive photosensitive composition according to the present invention comprises an alkaline solution containing (A) quaternary ammonium hydroxide; and (B) at least one compound selected from the group consisting of potassium pyrophosphate, sodium tripolyphosphate and sodium hexametaphosphate. It is preferable that a pH value of the developer according to the present invention is within a range of 9.1 to 13.5.

The quaternary ammonium hydroxide (A) is main material for keeping the developer alkaline and performing alkaline development. The quaternary ammonium hydroxide is preferably represented by the following Formula (1). Examples of the quaternary ammonium hydroxide preferably include tetraalkylammonium hydroxides such as tetramethylammonium hydroxide, tetraethylammonium hydroxide, tetrapropylammonium hydroxide, tetrabutylammonium hydroxide, benzyltrimethylammonium hydroxide and benzyltriethylammonium hydroxide.

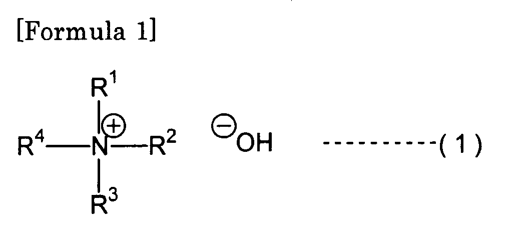

(where R¹ to R⁴ each indicate independently substituted or unsubstituted alkyl groups, and are preferably methyl groups, ethyl group, propyl groups, butyl groups or phenylmethyl groups.)

These quaternary ammonium hydroxides can be used singly or in combination of two or more thereof. A mixing ratio of the quaternary ammonium hydroxide (A) just has to be selected as appropriate according to the positive photosensitive composition to be applied, development conditions and the like, and however, it is preferable to mix the quaternary ammonium hydroxide at 0.01 to 5 wt%, more preferably 0.01 to 3 wt%, on the basis of the developer.

The compound (B) selected from the group consisting of potassium pyrophosphate, sodium tripolyphosphate and sodium hexametaphosphate has a buffer function by absorbing the carbonic acid gas to prevent the pH value of the developer from decreasing owing to carbonic acid gas entering the developer or generated therein. Although a mixing ratio of the compound (B) is not particularly limited, it is preferable to mix the compound (B) at 0.01 to 5 wt%, more preferably 0.05 to 2 wt% on the basis of the developer.

It is preferable to further mix (C) trisodium phosphate to the developer according to the present invention. The trisodium phosphate (C) also has the buffer function to prevent the pH value from decreasing. Although a mixing ratio of the compound (C) is not particularly limited, it is appropriate to set a mixing ratio (weight ratio) of the component (B) to the component (C) at 1: 0.1 to 1, preferably 1: 0.2 to 0.5, in order to strengthen the buffer function.

It is preferable to further mix a surfactant (D) to the developer according to the present invention. The surfactant (D) functions to help the developer exhibit activity and permeate through a photosensitive film of an exposed portion, and to promote dissolution of the photosensitive film. As the surfactant (D), there are widely usable well-known surfactants such as anionic, cationic, nonionic and amphoteric ion surfactants. Specifically, preferable examples of the surfactant (D) include sodium ester of α-sulfofatty acid, sodium linear alkylbenzene sulfonate, sodium alkyl sulfate, sodium alkyl ether sulfate, sodium α-olefin sulfonate, sodium alkylsulfonate, ester of sucrose fatty acid, ester of sorbitan fatty acid, ester of polyoxyethylene sorbitan fatty acid, fatty acid alkanolamide, polyoxyethylene alkyl ether, polyoxyethylene alkyl phenyl ether, sodium ester of alkylaminofatty acid, alkyl betaine, alkyl amine oxide, alkyl trimethyl ammonium salt, dialkyl dimethyl ammonium salt, and the like. These surfactants can be used singly or in combination of two or more thereof. Although a mixing ratio of the surfactant (D) is not particularly limited, the mixing ratio is preferably 0.1 to 1.2 wt%, more preferably 0.2 to 1.0 wt% on the basis of the developer.

It is preferable to further mix an accelerator (E) to the developer according to the present invention. The accelerator (E) functions not to remain the development residue. For example, the accelerator includes normal propanol, isopropanol, butanol, isoamyl alcohol, benzyl alcohol, dimethyl sulfoxide, N-methylpyrrolidone, ethylene glycol phenyl ether, ethylene glycol benzyl ether, cyclohexane, cyclohexanol, N-benzylethanolamine, anisyl alcohol, dimethylbenzyl alcohol, N-phenylethanolamine, propylene glycol monophenyl ether, tripropylene glycol monomethyl ether, phenylglycol, and the like. These accelerators can be used singly or in combination of two or more thereof. Although a mixing ratio of the accelerator (D) is not particularly limited, the mixing ratio is preferably 0.1 to 10 wt%, more preferably 0.1 to 5 wt%, on the basis of the developer.

The developer according to the present invention is applied for developing the positive photosensitive composition. The positive photosensitive composition is not particularly limited, and publicly known ones are widely usable. However, the developer is preferably used for an alkali-soluble positive photosensitive composition having sensitivity to an infrared wavelength laser, in which a sensing portion becomes soluble to the alkaline developer by being exposed to and sensing a laser beam with a wavelength of 650 to 1,300 nm, preferably 700 to 1,100 nm. As the positive photosensitive composition, there is specifically cited a composition containing, as essential components, an alkali-soluble polymer substance, and a photothermol conversion substance absorbing light of an image exposure light source and converting the light into heat. For example, the composition includes ones described in Patent Documents 1 to 6, PCT/JP2004/7272 and PCT/JP2004/9007, which were previously filed by the inventor of the present invention, and the like.

As the alkali-soluble polymer substance, there are preferable an alkali-soluble organic polymer substance having a phenol hydroxyl group, and an alkali-soluble organic polymer substance (hereinafter, referred to as a carboxyl group-containing organic polymer substance) having a -COOR (where R is a hydrogen atom or a monovalent organic group) group. The alkali-soluble organic polymer substance is a main component for forming resist, and is binder resin having low adhesion to a copper-plated surface or a copper sulfate-plated surface. A main or side chain portion of a molecule of the alkali-soluble organic polymer substance is cut by heat to convert into low molecules in which the alkali solubility is further enhanced. A part of the low molecules is ablated.

The organic polymer substance having a phenol hydroxyl group includes, for example, novolac resin, resol resin, polyvinyl phenol resin, a copolymer of an acrylic acid derivative having a phenol hydroxyl group, and the like. In particular, the novolac resin or the polyvinyl phenol resin is preferable.

The novolac resin is resin formed by polycondensing at least one of phenols with at least one of aldehydes and ketones under acidic catalyst. The resol resin is resin formed by performing similar polycondensation except that alkaline catalyst is used in place of the acidic catalyst in the polycondensation of the novolac resin. As the novolac resin and the resol resin, there are particularly preferable phenol, o-cresol, m-cresol, p-cresol, 2,5-xylenol, 3,5-xylenol, resorcinol, or mixed phenols thereof, or polycondensates of these with formaldehyde, acetaldehyde, or propionaldehyde. As each of the novolac resin and the resol resin, one is preferable, in which a weight average molecular weight (MW) in polystyrene conversion is 1,500 to 150,000 by gel permeation chromatography measurement.

As the polyvinyl phenol resin, for example, there is exemplified resin formed by polymerizing one or two or more of hydroxystyrenes under the presence of a radical polymerization initiator or a cationic polymerization initiator. There are also preferable polymers of hydroxystyrenes each having, as a substituent group, an alkyl group with carbon number of 1 to 4 in a benzene ring, and polymers of hydroxystyrenes each having a benzene ring without any substituent group.

As the carboxyl group-containing organic polymer substance, for example, there is exemplified a carboxyl group-containing polymer substance as described in PCT/JP2004/9007, and there are preferable a polymer obtained from an unsaturated compound (a1) having at least one carboxyl group and/or a carboxylic acid anhydride group, and a copolymer obtained from the unsaturated compound (a1) and a compound (a2) copolymerizable with the unsaturated compound. Specifically, preferable examples include a maleic acid polymer, a (meth)acrylic acid polymer, a styrene/maleic acid-series copolymer and derivatives thereof, and there is particularly preferable a styrene/maleic acid-series copolymer obtained by reacting a compound having a hydroxyl group with the styrene/maleic anhydride-series copolymer.

These alkali-soluble polymer substances can be used singly or in combination of two or more thereof. A content ratio of the alkali-soluble organic polymer substance in the positive photosensitive composition is preferably 2 to 98 wt%, more preferably 30 to 90 wt%.

As the photothermol conversion substance, known photothermol conversion substances are widely usable. For example, the photothermol conversion substance includes organic or inorganic pigment and dye each having an absorption band in a part or all of the infrared range with the wavelength range of 650 to 1300 nm, absorbing an infrared ray, and converting the infrared ray into heat, and photothermol conversion colorants such as organic colorant, metal, metal oxide, metal carbide, and metal boride, as described in Patent Documents 1 to 6. These photothermol conversion substances get involved in lowering molecular weight and ablation of the alkali-soluble nature caused by the thermal cutting of the molecules of the alkali-soluble organic polymer substance.

As representative one of the photothermol conversion substances, there is exemplified so-called cyanine colorant in a broad sense, in which heterocycles containing nitrogen atoms, oxygen atoms, sulfur atoms or the like are bonded by polymethine (-CH=)n. Specifically, for example, the cyanine colorant includes ones of quinoline series (so-called cyanine series), indole series (so-called indocyanine series), benzothiazole series (so-called thiocyanine series), iminocyclohexadiene series (so-called polymethine series), pyrylium series, thiapyrylium series, squaryllium series, croconium series, azulenium series, and the like. Among them, the colorants of quinoline series, indole series, benzothiazole series, iminocyclohexadiene series, pyrylium series or thiapyrylium series are preferable.

These photothermol conversion substances can be used singly or in combination of two or more thereof. A content ratio of the photothermol conversion substance in the positive photosensitive composition is preferably 2 to 60 wt%, more preferably 3 to 50 wt%.

It is preferable that the positive photosensitive composition contains various additives such as an adhesion improver, a dissolution inhibitor, a photoacid generator, dye, an intensifier, an accelerator and a coat improver. The adhesion improver is preferably at least one selected from the group consisting of vinylpyrrolidone/vinyl acetate copolymer, vinylpyrrolidone/ dimethylaminoethyl methacrylate copolymer, vinylpyrrolidone/vinylcaprolactam/dimethylaminoethyl methacrylate copolymer, polyvinyl acetate, polyvinyl butyral, polyvinyl formal, terpenephenol resin, alkylphenol resin, melamine/formaldehyde resin, and ketone resin.

In usual, the positive photosensitive composition is used as a solution obtained by dissolving the respective components into a solvent such as a cellosolve solvent and a propylene glycol solvent. A usage ratio of the solvent is usually within a range of 1 to 20 times a total amount of solid contents of the photosensitive composition on a weight ratio basis.

With regard to the developer according to the present invention, it is preferable to prepare a stock solution of the developer, in which concentrations of the respective components are enhanced, to dilute the stock solution before use, and to use the diluted solution as the developer. Although usage of the developer according to the present invention is not particularly limited, the following usage is preferable. The stock solution of the developer and water are mixed and vatted, and the positive photosensitive composition is coated on a support surface (for example, in the case of gravure printing, on a copper-plated surface or copper sulfate-plated surface of a roll to be processed for the gravure printing), and a photosensitive film is formed. Thereafter, the photosensitive film is irradiated with a near-infrared wavelength laser in a blinking manner, thus being exposed thereto to draw a positive latent image thereon, and then the development is performed.

A development method is not particularly limited, and known methods are adopted. In usual, the development is performed at a temperature ranging from 15 to 45°C, preferably 22 to 32°C by means of immersion development, spray development, brush development, ultrasonic development, and the like.

As a coating method of the positive photosensitive composition on the support surface, there are usable kiss coating, dip coating, rotation coating, roll coating, wire bar coating, air knife coating, blade coating, curtain coating, and the like. It is preferable to set a coating amount within a range of 1 to 6 µm in terms of thickness.

### Example:

The present invention is described more specifically by way of examples below. It is needless to say that these examples are described only for illustration purposes, and should not be restrictively construed.

### (Examples 1 to 8)

A roll to be processed was attached onto a photosensitive film coating apparatus (made by Think Laboratory Co., Ltd.) installed in a coating chamber in which humidity was maintained at 40% or less, and a positive photosensitive composition was coated thereon. Subsequently, the positive photosensitive composition was dried at 130°C, and a positive photosensitive film was formed so that a remaining solvent could become 2% or less and a film thickness could be 2 to 3 µm. Next, the positive photosensitive film was irradiated with a laser with a wavelength of 830 nm in a blinking manner by means of a laser exposure apparatus, thus being exposed thereto to draw a positive latent image thereon. Thus, a roll to be tested was prepared. Incidentally, as the positive photosensitive composition, there was used a photosensitive solution A [100 parts by weight of PR-NMD-100 (made by Sumitomo Bakelite Co., Ltd., novolac resin), 1 part by weight of cyanine colorant, 5 parts by weight of vinylpyrrolidone/vinyl acetate copolymer, 5 parts by weight of TrisP-PA (made by Honshu Chemical Industry Co., Ltd., dissolution inhibitor), 800 parts by weight of propylene glycol monomethyl ether (PM), 800 parts by weight of isopropyl alcohol (IPA), and 600 parts by weight of methylethylketone (MEK)].

A stock solution of a developer with a composition shown in Table 1 was prepared, and the stock solution of the developer was diluted with water in a development tank (ratio of water and stock solution: 3: 1), and the developer was prepared. Incidentally, pH of the developer was within a range of 12.9 to 13.3. The roll to be tested was set in a development apparatus, and the development was performed for 50 seconds. Then, in all of Examples 1 to 8, a good development without any residue on an image area of a resist screen (that is, a portion from which resist was removed) and with good pattern sharpness was realized. Thereafter, the developing treatment was continuously performed for 600 rolls without exchanging the developer. Then, even after treating the 600 rolls, the developers of Examples 1 to 8 stably maintained the pH value at 12.9 or more, and realized the good development with the good pattern sharpness in a short time. Moreover, the deterioration with time in the treatment capability of each developer was extremely small, and each developer of Examples 1 to 8 had a good developing capability even after the elapse of two days to one week from the development.

**[Table 1]**

| | Example | | | | | | | | Experimental example |
|---|---|---|---|---|---|---|---|---|---|
| | 1 | 2 | 3 | 4 | 5 | 6 | 7 | 8 | 1 |
| (A)TEA-OH | 5.3 | 5.3 | 5.3 | 5.3 | 5.3 | 5.3 | 5.3 | 5.3 | 5.3 |
| (B) Potassium pyrophosphate | 0.6 | 1.7 | - | - | 0.9 | 0.9 | - | 0.6 | - |
| (B)Sodium tripolyphosphate | 0.6 | - | 1.7 | - | 0.8 | - | 0.9 | 0.6 | - |
| (B) Sodium hexametaphosphate | 0.6 | - | - | 1.7 | - | 0.8 | 0.8 | 0.6 | - |
| (C) Trisodium phosphate | 0.6 | 0.5 | 0.4 | 0.8 | 0.6 | 0.5 | 0.3 | - | 0.6 |
| (D) Surfactant | 2.0 | 0.8 | 3.5 | 1.0 | 2.0 | 0.5 | 1.5 | - | 2.0 |
| (E) Accelerator | 1.0 | 1.0 | 1.0 | 1.0 | 1.0 | 1.0 | 1.0 | - | 1.0 |

Mixing amount of the mixing substances in Table 1 are indicated by wt%, and the respective components are as follows. Note that a residual component of the developer is water.
TEA-OH: tetraethylammonium hydroxide
Trisodium phosphate: Na₃PO₄ · 12H₂O
Surfactant: fatty acid alkanolamide
Accelerator: isopropanol

### (Experimental example 1)

The development was performed in a similar way to Example 1 except that the composition of the stock solution of the developer was changed as in Table 1. Then, a residue was observed a little on the image area of the resist screen. Moreover, a treatment capability here was only for several rolls, and on the following day from a day when the development was performed, the treatment capability was entirely lost though a decrease of the pH value was not observed.

### (Examples 9 to 19)

The development was performed in a similar way to Example 1 except that the stock solutions of developers, which were obtained by mixing compounds shown in Table 2, were used in place of TEA-OH as the quaternary ammonium hydroxide (A). Then, as in Example 1, each of the developers was extremely good in developing capability and stability with time, and was capable of developing 600 rolls.

**[Table 2]**

| Composition (A) | Example number | | | | | | | | | | |
|---|---|---|---|---|---|---|---|---|---|---|---|
| | 9 | 10 | 11 | 12 | 13 | 14 | 15 | 16 | 17 | 18 | 19 |
| TEA-OH | - | - | - | - | - | 2.6 | 1.7 | 1.3 | - | - | - |
| TMA-OH | 5.3 | - | - | - | - | 2.6 | 1.8 | 1.3 | - | - | - |
| BETEA-OH | - | 5.3 | - | - | - | - | 1.8 | 1.3 | 2.6 | 1.7 | 1.3 |
| BTMA-OH | - | - | 5.3 | - | - | - | - | 1.3 | 2.6 | 1.8 | 1.3 |
| TBA-OH | - | - | - | 5.3 | - | - | - | - | - | 1.7 | 1.3 |
| TPA-OH | - | - | - | - | 5.3 | - | - | - | - | - | 1.3 |

Mixing amount of the mixing substances in Table 2 are indicated by wt%, and the respective components are as follows.
TEA-OH: tetraethylammonium hydroxide
TMA-OH: tetramethylammonium hydroxide
BETEA-OH: benzyltriethylammonium hydroxide
BTMA-OH: benzyltrimethylammonium hydroxide
TBA-OH: tetrabutylammonium hydroxide
TPA-OH: tetrapropylammonium hydroxide

### (Example 20)

The development was performed in a similar way to Example 1 by using, as the positive photosensitive composition, a photosensitive solution B in which the novolac resin in the photosensitive solution A was changed to a partial ester compound derived from butyl cellosolve of a styrene/maleic anhydride copolymer. Incidentally, the pH value of the developer was 9.5. As in Example 1, the developer of Example 20 was extremely good in developing capability and stability with time, and was capable of developing 600 rolls.

## Claims

1. A developer for a positive photosensitive composition, comprising an alkaline solution containing:
(A) quaternary ammonium hydroxide; and
(B) at least one selected from the group consisting of potassium pyrophosphate, sodium tripolyphosphate and sodium hexametaphosphate.

2. The developer according to claim 1, wherein the alkaline solution further contains (C) trisodium phosphate.

3. The developer according to claim 1 or 2, wherein the alkaline solution further contains (D) a surfactant.

4. The developer according to any one of claims 1 to 3, wherein the alkaline solution further contains (E) an accelerator.

5. The developer according to any one of claims 1 to 4, wherein the quaternary ammonium hydroxide (A) is at least one selected from the group consisting of tetramethylammonium hydroxide, tetraethylammonium hydroxide, tetrapropylammonium hydroxide, tetrabutylammonium hydroxide, benzyltrimethylammonium hydroxide and benzyltriethylammonium hydroxide.
